Europäisches Patentamt

European Patent Office

Office européen des brevets

(11) Publication number: **0 206 231**
A2

# (12) EUROPEAN PATENT APPLICATION

(21) Application number: **86108269.1**

(22) Date of filing: **18.06.86**

(51) Int. Cl.⁴: **H 05 K 3/34**, B 23 K 1/08

(30) Priority: **21.06.85 IT 2124885**

(43) Date of publication of application: **30.12.86**
**Bulletin 86/52**

(84) Designated Contracting States: **BE CH DE FR GB LI NL**

(71) Applicant: **IEMME ITALIA S.p.A., 106, Via Erba,
I-20037 Paderno Dugnano (Milan) (IT)**

(72) Inventor: **Vassallo, Federico, Via Borgazzi, 134,
I-20052 Monza (Milano) (IT)**

(74) Representative: **Marietti, Giuseppe, CENTRO DI
CONSULENZA IN PROPRIETA' INDUSTRIALE Viale
Caldara, 43, I-20122 Milano (IT)**

(54) **A method and device for soldering electronic components on printed circuit boards.**

(57)    The invention concerns a method and device for soldering electronic components on printed circuit boards using one or more solder waves.

The method according to the invention, which is of the type in which the streams of solder comprising the wave flow lie in vertical planes perpendicular to the direction of advancement of the boards, is characterized in that the streams of solder are given a horizontal motion component lying in said planes.

Such a method is carried-out by a device of the type with at least one solder delivery nozzle shaped and positioned so that the streams of solder comprising the wave flow in vertical planes perpendicular to the direction of movement of the boards, said device being characterized in that the nozzle contains a number of deflector vanes inclined to the vertical which impart to the solder streams a horizontal motion component lying in said planes.

The present invention concerns a method and a device for soldering electronic components, in particular surface-mounted types, to printed circuit boards by one or more waves of solder which bathe the surface of the boards and effect the soldering of the components to the printed circuit boards.

A method is known for soldering so called surface-mounted electronic components to printed circuit boards in which the components are first pre-attached to the board which is then fixed to a conveyor which passes it glancingly over one or more successive waves of molten solder, which wash the board and penetrate into the spaces between the board and the components, soldering the latter to the printed circuit board. In general, there are two succesive solder waves; the first has a more turbulent flow to better penetrate by the solder the spaces between the components and the board, and actually solders the components,while the second is a solder-finisher, removing points and short-circuits.

In such known methods the wave of solder is directed vertically from below so that each solder stream comprising the wave itself, at the point of contact between the solder and the board, liess in a vertical plane, parallel to the direction of advancement of the board. This method, especially for components which are mounted very close

1

together and for certain board component layouts, gives rise to areas not washed by the solder wave due to air or flux-vapour bubbles being trapped in the areas to be soldered.

The main object of the present invention is to provide a method and a device which eliminate the above-mentioned drawback of the soldering method and device as known up to now, and allow the soldering of components attached to the board, even when they are grouped very close together and/or have a complex mounting geometry.

This object is achieved by a solder-wave soldering method wherein the streams of solder comprising the wave, up to the point where they leave the nozzle, lie in vertical planes perpendicular to the direction of advancement of the boards, and which is characterized by the imparting to the solder streams a horizontal motion component lying in said planes.

The method according to the invention is carried-out by a device consisting of at least one solder delivery nozzle shaped and positioned in such a way that the streams of solder comprising the wave are delivered in vertical planes perpendicular to the direction of advancement of the boards themselves, and characterized in that such a nozzle has a number of deflector vanes which are inclined to the vertical such as to give to the fluid streams a horizontal motion component to the fluid streams lying in said planes.

2

Such a horizontal motion component favours the flow of the solder along the walls of the electronic components pre-attached to the boards, independently from the orientation of these walls in relation to the direction of advancement of the board. This improved flow of solder prevents air or flux-vapour bubbles from being trapped in areas to be soldered, and allows the solder to bathe the board completely.

The method according to the invention has the advantage that it can be carried-out by a conventional device through the simple addition of the aforementioned deflector vanes to the solder wave nozzle.

The main characteristics and details of the above method and device will be now described with reference to the accompanying drawing, in which:

Figure 1 is a perspective schematic view of the device.

Figure 2 is a cross-section according to line A - A of fig.1.

Figure 3 is a cross-section according to line B - B of fig.2.

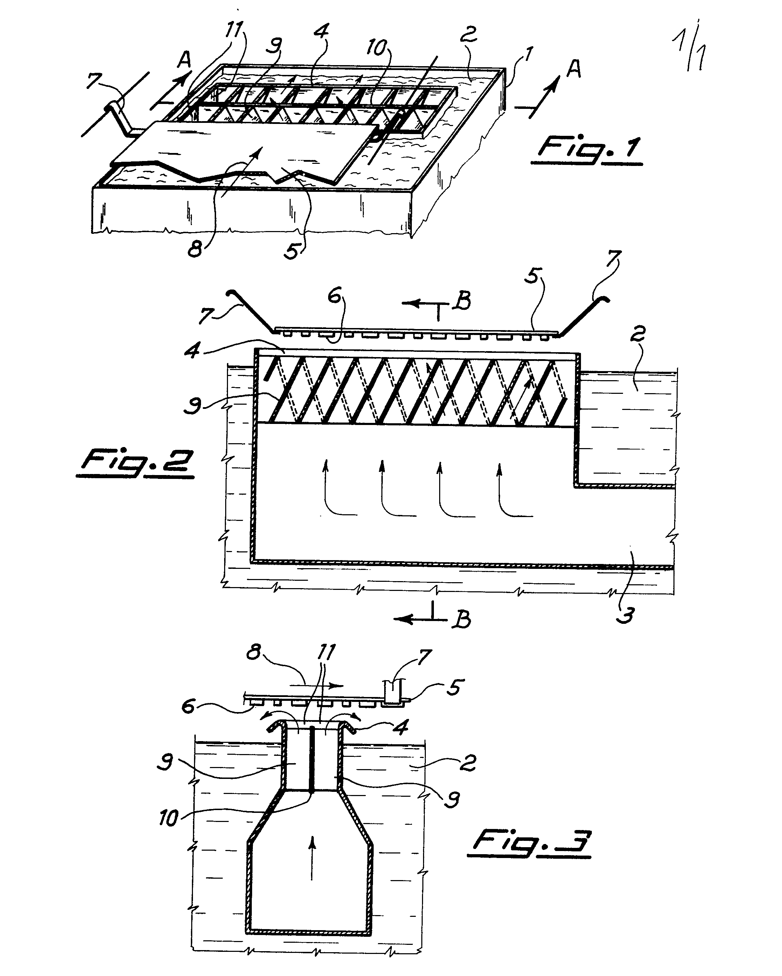

With reference to the accompanying drawing, the device according to the invention essentially consists, in a well known way, of a reservoir 1 containing a solder in molten form, indicated generally as 2, and a pumping device which raises the solder from the reservoir 1 and forces it through

3

a pipe 3 to a nozzle 4 where it flows out as a soldering wave.

On the lower surface of a printed circuit board 5 are pre-attached electronic components 6 which are to be soldered to the electric circuits printed on the board itself. For this purpose, each board 5 is fixed to a conveyor 7 which moves it in the direction indicated by arrow 8 and passes it across the wave of solder flowing from the nozzle 4; in this way the wave of solder bathes the electric components 6 and the lower surface of the board 5 and so soldering the components to the electric circuits printed on the board itself.

In order to allow the solder to reach all the spaces between the board and the electronic components even where the latter are very close together or have horizontal walls differently inclined with respect to the direction of advancement of the boards, the nozzle 4 contains a number of deflector vanes 9 which divert the streams of solder forming the wave and give them a horizontal motion component.

In greater detail, the nozzle 4, which is rectangular in cross-section and has its longest dimension perpendicular to the direction of advancement of the boards 5, is oriented in such a way that the solder streams forming the jet of solder flowing from the nozzle itself lie in vertical planes perpendicular to the direction of advancement of the boards.

4

In the interior of nozzle 4 there is a vertical wall 10, parallel to the nozzle long axis, which divides the nozzle into two outlets 11. In the interior of each outlet 11 there are deflector vanes 9 whose upper and lower edges are parallel to the direction of advancement of the boards 5 and whose lateral edges are inclined with reference to the vertical. In particular, the deflector vanes in one outlet form a positive angle with the vertical, while in the other outlet the angle formed by said deflector vanes is negative. The deflector vanes in each of the two outlets are all equally inclined with respect to the vertical.

In this way, the solder under pressure from the pipe 3 is divided into two half flows by the vertical wall 10; the first half flow, before leaving the outlet 11 and falling within the reservoir in a direction opposite to the advancing direction of boards 5, passes the deflector vanes 9 and is given a horizontal motion component from left to right in a plane perpendicular to the direction of advancement of the boards 5; the second half flow, before leaving its corresponding outlet 11 and falling within the reservoir in the same direction as the advancing direction of boards 5, passes the other series of deflector vanes 9 which give it a horizontal motion component from right to left in a plane perpendicular to the direction of advancement of the boards 5.

In this way, the electronic components pre-attached to the boards 5 are struck by two crossed jets of solder which, due to the horizontal motion components given by the deflector vanes 9, flow over the surface of the board penetrating all the spaces between the board itself and the electronic components, improving the removal of air and flux-vapour bubbles.

The nozzle 4 can be divided by more than one vertical wall 10 into many outlets 11, each with its series of deflector vanes 9 inclined in the opposite direction to those in the next outlet.

Other conventional solder-finishing equipments e.g. by a solder wave can be installed downstream of the nozzle according to the invention.

As described above, the method according to the invention can be used with conventional machines by the simple addition of the dividing walls and the deflector vanes to the solder nozzle.

CLAIMS

1) A method for soldering electronic components onto printed circuit boards (5) using at least one solder wave across which the boards (5) are passed so that the wave itself bathes the electronic components and the boards and effects their soldering, the streams of solder comprising the wave flowing, up to the point of leaving a nozzle (4), in vertical planes perpendicular to the direction of advancement (8) of the boards (5), characterized in that the streams are given a horizontal motion component lying in said planes.

2) A device for carrying-out the method according to claim 1, of the type consisting of at least one nozzle (4) for the solder wave, shaped and positioned in such a way that the streams of solder comprising the wave, up to the point of leaving the nozzle (4), lie in vertical planes perpendicular to the direction of advancement of the boards (5), characterized in that said nozzle (4) contains a series of deflector vanes (9), inclined with respect to the vertical, in order to impart to the streams a horizontal motion component lying in said planes.

3) A device according to claim 2, in which the nozzle (4) of the solder wave is rectangular in cross-section with its long axis perpendicular to the direction of the advancement (8) of the boards, characterized in that said

7

nozzle (4) is divided internally by at least one vertical wall (10) into two or more successive outlets (11), inside of each of which are located said deflector vanes (9), the vanes (9) in one outlet forming the same angle with the vertical, but in the opposite sense, as the vanes (9) in the next outlet.

4) A device according to claim 3, characterized in that said deflector vanes (9) in each outlet (11) are equally inclined with respect to the vertical.

5) A device according to one of claims 2 to 4, characterized in that one or more solder-finishing devices are installed downstream of the soldering device.

*Fig.1*

*Fig.2*

*Fig.3*